# EUROPEAN PATENT APPLICATION

(11) **EP 1 727 413 A1**
(43) Date of publication of application: **29.11.2006**
(21) Application number: 06075654.1
(22) Date of filing: 23.03.2006
(51) Int. Cl.: H05K 13/02

(54) **A method for supplying a component, as well as a component supplying device**

(30) Priority: 23.05.2005 NL 1029098
(71) Applicant: Assembléon N.V., 5600 KA Eindhoven (NL)
(72) Inventor: Hoogers, Hubert Francijn Maria, 5513 BR Wintelre (NL)
(74) Representative: Dohmen, Johannes Maria Gerardus

(57) **Abstract**

A method for supplying a component to a pick-up position located near a stop by means of a component supplying device comprising a guide provided with said stop, at least one air inlet opening connected to said guide and at least one air outlet opening connected to said guide. Components are carried through the guide in a direction of transport towards the stop by means of air being supplied through the air inlet opening. Once a number of components have been transported in the direction of transport, the air outlet opening is closed by at least one component present in the row, after which at least one component following said row is transported in a direction opposed to the direction of transport.

## Description

The invention relates to a method for supplying a component to a pick-up position located near a stop by means of a component supplying device comprising a guide provided with said stop, at least one air inlet opening connected to said guide and at least one air outlet opening connected to said guide, wherein components are carried through the guide in a direction of transport towards the stop by means of air being supplied through the air inlet opening.

The invention also relates to a component supplying device comprising a guide provided with a stop, at least one air inlet opening connected to said guide and at least one air outlet opening connected to said guide, wherein components are carried through the guide in a direction of transport towards the stop by means of air being supplied through the air inlet opening.

With such a method and device as known from European patent application EP-A1-0 684 757, the components are contained in a cassette. The cassette is connected to the component supplying device, and the components are carried from the cassette to a pick-up position located near a stop via said guide. At the pick-up position, a component is picked up by means of a pick-up unit and placed on a substrate, for example.

In many cases, components are also transported from the cassette into the guide under the influence of the force of gravity. The forces exerted on the components in the guide by the air and possibly by the force of gravity may cause the component that is located near the stop to abut firmly against said stop. As a result, a relatively large force must be exerted on the component for pulling the component from its position between the stop and the next component upon picking up the component.

The object of the invention is to provide a method wherein components can be moved to a pickup position in a reliable manner, and wherein the component that is present at the pickup position can be picked up relatively easily.

This object is accomplished with the method according to the invention in that the air outlet opening is closed by at least one component present in the row once a number of components have been transported in the direction of transport, after which at least one component following said row is transported in a direction opposed to the direction of transport.

The number of components that abut against the component that is present near the stop is thus known in advance, as a result of which also the forces exerted on the component that is present near the stop are known in advance.

One embodiment of the method according to the invention is characterised in that the air outlet opening is closed by the component that is positioned furthest away from the stop.

The spacing between the stop and the air outlet opening can be determined in advance, in such a manner that the number of components present between the stop and the air outlet opening will be such that said components will not exert an undesirably large force on the components that are located near the stop.

Yet another embodiment of the method according to the invention is characterised in that a component is picked up from the pickup position near the stop, after which the row of components is moved in the direction of the stop under the influence of the air that is being supplied, the air outlet opening is released and at least said one component following said row is moved to join the row until the air outlet opening is closed again.

Further movement of the row in the direction of transport will take place automatically after the component present near the stop has been removed. A next component is now positioned into abutment with the stop and a next component is added to the row on a side of the row remote from the stop.

The invention also relates to a component supplying device that is characterized in that the air outlet opening can be closed by a component.

Since the air outlet opening can be closed by a component, the components following the row can be prevented from being transported onwards in the direction of transport by means of air in a relatively simple manner.

The invention will now be explained in more detail with reference to the drawings, in which:
Figure 1 shows a guide of a component supplying device according to the invention with the air outlet openings in the open position;
Figure 2 shows the guide of figure 1 with the air outlet openings in the closed position;

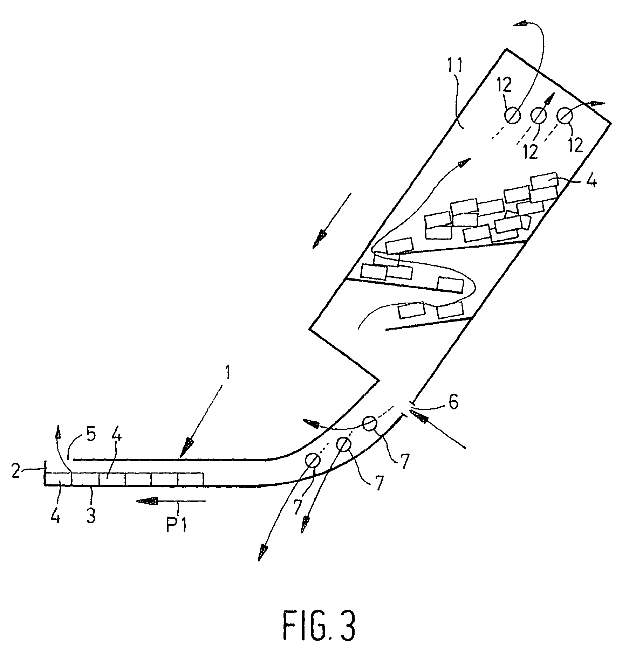

Figure 3 is a sectional view of a component supplying device according to the invention provided with a guide as shown in figures 1 and 2.

Like parts are indicated by the same numerals in the figures.

A component supplying device is known, for example from EP-A1-0 684 757.

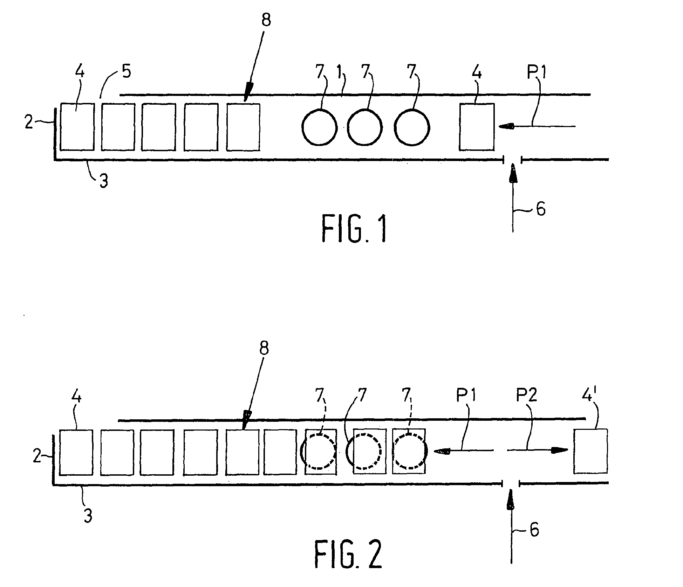

The component supplying device according to the invention comprises a cassette 11 containing components and a tubular elongated guide 1 connected thereto, which guide comprises a stop 2 near one end and a pickup position 3 located near the stop 2, from where a component 4 can be picked up through a recess 5 in the guide 1. The guide 1 is provided with at least one air inlet opening 6 and three air outlet openings 7 located between the stop 2 and the air inlet opening 6. The dimensions of the air outlet openings 7 are smaller than those of the components 4. Components 4 from the cassette 11 are introduced into the guide 1, for example under the influence of the force of gravity, and subsequently moved in the direction of transport indicated by the arrow P1 towards the stop 2 by means of air being introduced via the air inlet opening 6. Once a first component 4 abuts against the stop 2, a next component 4 is positioned into abutment with said component 4, as a result of which a row 8 of components is formed. In the situation that is shown in figure 1, the air outlet openings 7 are free and the air that is being introduced into the guide 1 via the air inlet opening 6 is discharged through the air outlet openings 7.

In the situation that is shown in figure 2, the row 8 of components 4 is so long that the air outlet openings 7 are practically completely closed by the components 4. In this situation, the air being supplied through the air inlet opening 6 can no longer be discharged and the component 4' that is moving in the direction of the row 8 will move away from the row 8 in a direction P2 opposed to the direction of transport P1, back into the cassette 11. In this way the number of components present between component 4 that abuts against the stop 2 and the last component 4 of the row 8 will be practically constant at all times and there will be no pushing of components 4 against the stop 2.

The air that is blown into the cassette 11 via the opening 6 exits the cassette 11 via air outlet openings 12.

The number of air outlet openings 7 may be larger or smaller than three, said number depending on, among other factors, the amount of air which is required for said transport and which must subsequently be discharged, therefore. In the case of heavier components, more air is required than in the case of lighter components.

## Claims

1. A method for supplying a component to a pick-up position located near a stop by means of a component supplying device comprising a guide provided with said stop, at least one air inlet opening connected to said guide and at least one air outlet opening connected to said guide, wherein components are carried through the guide in a direction of transport towards the stop by means of air being supplied through the air inlet opening, **characterised in that** the air outlet opening is closed by at least one component present in the row once a number of components have been transported in the direction of transport, after which at least one component following said row is transported in a direction opposed to the direction of transport.

2. A method according to claim 1, **characterised in that** the air outlet opening is closed by the component that is positioned furthest away from the stop.

3. A method according to either one of the preceding claims, **characterised in that** a component is picked up from the pickup position near the stop, after which the row of components is moved in the direction of the stop under the influence of the air that is being supplied, the air outlet opening is released and at least said one component following said row is moved to join the row until the air outlet opening is closed again.

4. A component supplying device comprising a guide provided with a stop, at least one air inlet opening connected to said guide and at least one air outlet opening connected to said guide, wherein components are carried through the guide in a direction of transport towards the stop by means of air being supplied through the air inlet opening, **characterised in that** the air outlet opening can be closed by a component.
